Europäisches Patentamt

European Patent Office

Office européen des brevets

(19)

(11) **EP 1 247 131 B1**

(12) **EUROPÄISCHE PATENTSCHRIFT**

(45) Veröffentlichungstag und Bekanntmachung des Hinweises auf die Patenterteilung:
**15.09.2004 Patentblatt 2004/38**

(21) Anmeldenummer: **00988634.2**

(22) Anmeldetag: **22.11.2000**

(51) Int Cl.⁷: $G02B \ 7/182$

(86) Internationale Anmeldenummer:
**PCT/DE2000/004116**

(87) Internationale Veröffentlichungsnummer:
**WO 2001/048527 (05.07.2001 Gazette 2001/27)**

(54) **MIKROSPIEGEL**

MICROMIRROR

MICROMIROIR

(84) Benannte Vertragsstaaten:
**DE ES FR GB IT SE**

(30) Priorität: **28.12.1999 DE 19963382**

(43) Veröffentlichungstag der Anmeldung:
**09.10.2002 Patentblatt 2002/41**

(73) Patentinhaber: **ROBERT BOSCH GMBH**
**70442 Stuttgart (DE)**

(72) Erfinder:
• **NIENDORF, Andreas**
**12527 Berlin (DE)**
• **FUNK, Karsten**
**Mountain View, CA 94041 (US)**

(56) Entgegenhaltungen:
**EP-A- 0 754 958       DE-A- 19 728 598**
**GB-A- 2 275 787       US-A- 5 748 172**

**Beschreibung**

Die Erfindung betrifft einen Mikrospiegel, insbesondere einen Mikroschwingspiegel, nach der Gattung des Hauptanspruchs.

Stand der Technik

Aus EP-A-754 958 ist ein Mikrospiegel gemäß dem Oberbegriff des Anspruchs 1 bekannt.

Ein Mikrospiegel und insbesondere ein Mikroschwingspiegel, der mit einem elektrostatischen Antrieb versehen ist, ist bereits in der Anmeldung DE 198 57 946.2 vorgeschlagen worden. Dabei wird eine weitgehend freitragende Spiegelfläche mit zwei oder gegebenenfalls vier sich paarweise gegenüberliegenden Federstegen oder Torsionsbalken mit einem umgebenden Tragkörper verbunden.

Aus US 5,748,172 ist weiter bereits ein Mikrospiegel mit einem magnetischen Antrieb bekannt. Dabei ist ebenfalls eine weitgehend freitragende Membran über zwei gegenüberliegende Torsionsbalken mit einem umgebenden Tragkörper verbunden, wobei sich auf der Unterseite der Spiegelfläche Leiterbahnen in Form von Leiterschleifen oder Wicklungen befinden, durch die ein elektrischer Strom geführt werden kann, so daß bei Anlegen eines äußeren Magnetfeldes ein Drehmoment auf die Spiegelfläche ausgeübt wird.

Aufgabe der vorliegenden Erfindung war die Entwicklung eines neuartigen Spiegeldesigns mit erhöhter mechanischer Belastungsfähigkeit, das insbesondere auch für einen magnetischen Antrieb geeignet ist. Die erhöhte mechanische Belastungsfähigkeit soll dabei dadurch erreicht werden, daß die die Spiegelfläche mit dem Tragkörper verbindenden Torsionsbalken oder Federstege stärker beziehungsweise belastbarer gegenüber Torsionen und Erschütterungen ausgebildet werden.

Vorteile der Erfindung

Der erfindungsgemäße Mikrospiegel hat gegenüber dem Stand der Technik den Vorteil einer höheren mechanischen Belastungsfähigkeit und höheren Bruchstabilität, wobei gleichzeitig relativ kleine elektrische Spannungen erforderlich sind, um die Spiegelfläche aus der Ruhelage auszulenken, beziehungsweise zu einer Torsionsschwingung anzuregen.

Weiter sind durch die erfindungsgemäße Ausbildung der Torsionsbalken vorteilhaft insgesamt höhere Antriebskräfte zur Auslenkung der Spiegelfläche als bei bekannten Mikrospiegeln erforderlich, was zu der erwähnten erhöhten Stabilität führt.

Schließlich ergibt sich dadurch, daß die Spiegelfläche erfindungsgemäß über mindestens zwei, zumindest näherungsweise parallel nebeneinander geführte Torsionsbalken mit dem Tragkörper verbunden ist bei vergleichbarer Biegefestigkeit eine im Vergleich zu einem einzelnen Torsionsbalken, der die gesamte Breite der parallelen Torsionsbalken und des dazwischen befindlichen Zwischenraumes einnimmt, verminderte Torsionssteifigkeit. Somit werden bei erhöhter Stabilität des gesamten Spiegeldesigns gleichzeitig größere Auslenkwinkel der Spiegelfläche möglich.

Vorteilhafte Weiterbildungen der Erfindung ergeben sich aus den in den Unteransprüchen genannten Maßnahmen.

So ist es besonders vorteilhaft, wenn die Spiegelfläche auf zwei gegenüberliegenden Seiten jeweils mit zwei beabstandet parallel nebeneinander geführten Torsionsbalken mit dem Tragkörper verbunden ist. Auf diese Weise kann auf der Oberfläche jedes Torsionsbalkens eine Leiterbahn aufgebracht werden, die die gesamte Oberfläche des Torsionsbalkens einnehmen kann, so daß sich eine optimale Nutzung der Breite des Torsionsbalkens bei gleichzeitiger Isolation der Leiterbahnen gegeneinander ergibt. Damit ist es insbesondere vorteilhaft möglich, besonders hohe elektrische Ströme von beispielsweise 10 mA bis 1 A über die auf der Oberfläche der Torsionsbalken befindlichen Leiterbahnen zu führen.

Weiter können die auf der Oberfläche der Torsionsbalken verlaufenden Leiterbahnen nun möglichst breit gemacht werden, da das Problem der elektrischen Isolation gegeneinander entfällt.

Insgesamt ergibt sich durch die verbreiterten Leiterbahnen und die optimale Ausnutzung der Oberfläche der Torsionsbalken somit eine höhere Strombelastbarkeit, was zu höheren magnetischen Kräften beziehungsweise Drehmomenten im Fall eines magnetischen Antriebes führt. Daher erlaubt es das erfindungsgemäße Design des Mikrospiegels nunmehr aufgrund der größeren erzeugbaren Kräfte vorteilhaft ein robusteres Design der Torsionsbalken zu wählen.

So ist nun die Gesamtbreite der beiden beabstandet parallel zueinander geführten Torsionsbalken zusammen mit der Breite des dazwischen befindlichen Zwischenraumes größer als die Breite eines entsprechenden, einzigen, aus dem Stand der Technik bekannten Torsionsbalkens.

Zudem ergibt sich vorteilhaft eine Torsionssteifigkeit des erfindungsgemäßen Federdesigns, die niedriger ist als die Torsionssteifigkeit eines einzelnen Torsionsbalkens, der die gesamte Breite der beiden parallelen Torsionsbalken und des zugehörigen Zwischenraumes einnimmt.

Das vorgestellte Federdesign kann im übrigen vorteilhaft auch auf Mikrospiegel übertragen werden, die zwei zueinander senkrechte Torsionsachsen aufweisen.

Vorteilhaft ist weiter, daß die Leiterbahnen auf der Oberfläche der Torsionsbalken, die bereichsweise auf dem Tragkörper befindlichen Kontaktflächen und die auf der Oberfläche der Spiegelflächen geführten Leiterbahnen in einfacher Weise durch an sich bekannte Verfahren zur Oberflächenmetallisierung erzeugt werden können.

Der erfindungsgemäße Mikrospiegel kann darüber hinaus sowohl mit einem elektrostatischen als auch mit einem magnetischen Antrieb ausgestattet sein.

Das Versehen der eigentlichen Spiegelfläche mit zwei im äußeren Bereich symmetrisch angebrachten Schleifen, die zu einer deutlichen Vergrößerung des von den auf der Oberfläche der Spiegelfläche geführten Leiterbahnen eingeschlossenen magnetischen Flusses in einem äußeren Magnetfeld führt, hat schließlich den Vorteil, daß diese Schleifen gleichzeitig als Anschlag für die Spiegelfläche dienen können, und damit diese und besonders auch die Torsionsbalken vor Stößen und kurzzeitigen Überlastungen schützt. Dazu ist vorteilhaft vorgesehen, daß die Schleifen bei zu starker Torsion der Spiegelfläche an die obere beziehungsweise untere Gehäuseseite oder den Tragkörper anschlagen, und so ein Brechen der Torsionsbalken verhindern.

Diese zusätzlichen Schleifen an der Spiegelfläche sind insbesondere dann vorteilhaft, wenn der erfindungsgemäße Mikrospiegel statisch ausgelenkt werden soll, und zur Erreichung einer möglichst kleinen Luftdämpfung ein Luftspalt zwischen Spiegelfläche und umgebenden Tragkörper vorgesehen ist.

Zusammenfassend hat der erfindungsgemäße Mikrospiegel den Vorteil großer Antriebskräfte bei gleichzeitig kleinen Antriebsspannungen, wobei sich gleichzeitig eine verbesserte Stabilität des Mikrospiegels und eine erhöhte Ausbeute bei der Herstellung ergibt, da die erzeugten Mikrostrukturen insgesamt robuster sind. Daneben kann der erfindungsgemäße Mikrospiegel vollständig mittels an sich bekannter Herstellungsverfahren hergestellt werden, so daß keine neuen Verfahrensschritte und Herstellungstechnologien in der Fertigung erforderlich sind

Zeichnungen

Die Erfindung wird anhand der Zeichnungen und in der nachfolgenden Beschreibung näher erläutert.

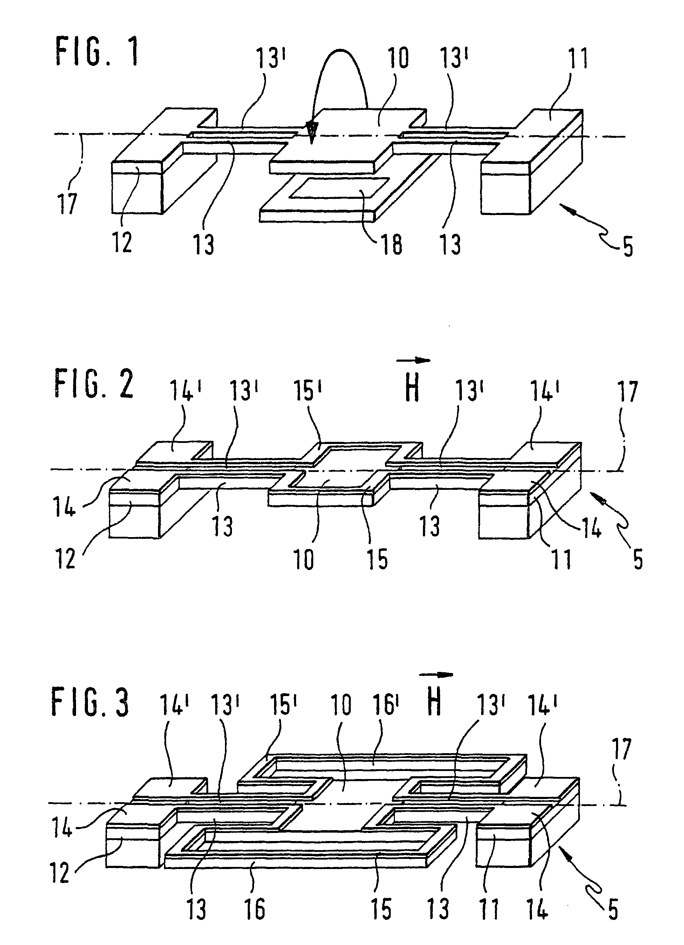

Die Figur 1 zeigt ein erstes Ausführungsbeispiel eines Mikrospiegels mit elektrostatischem Antrieb, die Figur 2 zeigt eine zweite Ausführungsform mit magnetischem Antrieb, und die Figur 3 zeigt eine dritte Ausführungsform eines Mikrospiegels mit magnetischem Antrieb.

Ausführungsbeispiele

Die Figur 1 zeigt einen Mikrospiegel 5, der in Form eines Mikroschwingspiegels ausgeführt ist.

Im einzelnen ist dazu aus einem Tragkörper 11, 12 aus beispielsweise Silizium in an sich bekannter Weise der dargestellte Mikrospiegel 5 herausstrukturiert worden, wobei eine Spiegelfläche 10 in Form eines Rechteckes mit Abmessungen von typischerweise 100 µm x 100 µm bis 400 µm x 400 µm vorgesehen ist, die an zwei gegenüberliegenden Seiten mit jeweils zwei, parallel beabstandet nebeneinander geführten Torsionsbalken 13, 13' versehen ist. Die Torsionsbalken 13, 13', die als Federstege wirken, verbinden die Spiegelfläche 10 mit dem die Spiegelfläche beispielsweise seitlich und im unteren Bereich umgebenden Tragkörper 11, 12, so daß die Spiegelfläche 10 weitgehend freitragend ist. Der Tragkörper 11, 12 ist dazu beispielsweise ein Siliziumwafer.

Die Torsionsbalken 13, 13' haben weiter eine Länge von 10 µm bis 100 µm, eine Höhe von 2 µm bis 10 µm und eine Breite von 5 µm bis 15 µm. Sie sind zudem in einem Abstand von 2 µm bis 5 µm parallel zueinander angeordnet, so daß sich ein dem Abstand entsprechender Zwischenraum zwischen den Torsionsbalken 13, 13' ergibt.

Unterhalb der Spiegelfläche 10 befindet sich zur Realisierung eines elektrostatischen Antriebs eine Elektrodenfläche, auf der bereichsweise in an sich bekannter Weise eine Elektrode 18 aufgebracht ist. Zudem ist vorgesehen, die Spiegelfläche zumindest bereichsweise, insbesondere auf der Unterseite, mit einer Metallisierung zu versehen, die über die Torsionsbalken 13, 13' geführte Leiterbahnen mit einer äußeren Spannungsversorgung verbunden ist.

Auf diese Weise kann durch Anlegen einer elektrischen Spannung an die Elektrode 18 beziehungsweise die Spiegelfläche 10 eine elektrostatische Kraft zwischen der Spiegelfläche 10 und der Elektrode 18 ausgeübt werden, daß eine Auslenkung der Spiegelfläche 10 um eine Torsionsachse 17 eintritt, die parallel zu der durch die Torsionsbalken 13, 13' definierten Achse liegt.

Auf weitere Ausführungen zu dem Ausführungsbeispiel gemäß Figur 1, insbesondere weiterer Details zur Herstellung des Mikrospiegels 5, zur elektrischen Steuerung und Anschlußkontaktierung, sei verzichtet, da diese Details dem Fachmann an sich bekannt sind.

Die Figur 2 zeigt eine alternative Ausführungsform des Ausführungsbeispiels gemäß Figur 1, wobei anstelle eines elektrostatischen Antriebs nunmehr ein magnetischer Antrieb eingesetzt wird. Dazu sind auf der Oberfläche der Spiegelfläche 10 zumindest einseitig Leiterbahnen 15, 15' vorgesehen, die zweckmäßig am äußeren Rand der Spiegelfläche geführt sind, so daß sie eine möglichst große Fläche auf der Spiegelfläche 10 einschließen. Die Leiterbahnen 15, 15' sind beispielsweise in an sich bekannter Weise durch bereichsweises Aufbringen von Oberflächenmetallisierungen, beispielsweise aus Gold, erzeugt worden. Damit die Leiterbahnen 15, 15' in Figur 2 einen möglichst großen elektrischen Strom tragen können, ist es weiter zweckmäßig, die Leiterbahnen 15, 15' möglichst dick und flächig auszubilden.

Die Leiterbahnen 15, 15' sind ausgehend von der Spiegelfläche 10 über die jeweils zugeordneten Torsionsbalken 13 beziehungsweise 13' zu elektrischen Kontaktflächen 14, 14' geführt, die beispielsweise in an sich bekannter Weise auf dem Tragkörper 11, 12 aufgebracht sind. Dabei nehmen die Leiterbahnen 15, 15' jeweils die gesamte Oberfläche des ihnen jeweils zugeordneten Torsionsbalkens 13 beziehungsweise 13' ein.

Die elektrische Trennung der beiden Leiterbahnen 15, 15' wird durch den zwischen den Torsionsbalken 13, 13' befindlichen Zwischenraum gewährleistet.

Die Dicke der Leiterbahnen 15, 15' beträgt bevorzugt 100 nm bis 2 μm, sie kann jedoch auch 10 μm erreichen. Ihre Breite liegt zweckmäßig zwischen 5 μm und 50 μm. Die Leiterbahnen 15, 15' bestehen im übrigen bevorzugt aus Gold.

In der Figur 2 ist weiter durch das eingetragene Symbol H angedeutet, daß sich der Mikrospiegel 5 gemäß Figur 2 im einem äußeren Magnetfeld befindet.

Bei Betrieb des Mikrospiegels 5 durch Anlegen einer äußeren elektrischen Spannung von beispielsweise 10 V bis 30 V an zwei benachbarte Kontaktflächen 14, 14' und durch Schließen des Stromkreises mit Hilfe der beiden verbliebenen, gegenüberliegenden Kontaktflächen 14, 14' fließt somit ein elektrischer Strom I von beispielsweise 10 mA bis 500 mA über die Leiterbahnen 15, 15', so daß sich durch die erläuterte Anordnung der Leiterbahnen 15, 15' eine geschlossene Leiterschleife bildet, die eine durch die Dimension der Spiegelfläche 10 definierte Fläche A einschließt.

Damit wird durch den angelegten elektrischen Strom I und das äußere Magnetfeld H ein Drehmoment T auf die Spiegelfläche 10 ausgeübt, wobei gilt:

$$\vec{T} = \vec{I} \cdot \vec{A} \times \vec{B} \qquad \text{und} \qquad \vec{B} = \mu_0 \mu_r \vec{H}$$

Dieses Drehmoment T, das proportional dem anliegenden elektrischen Strom I, der Stärke des äußeren Magnetfeldes B bzw H und der von der Leiterschleife eingeschlossenen Fläche A ist, bewirkt somit eine Verdrehung bzw. Torsions der Spiegelfläche 10 um die Torsionsachse 17. Bei geeigneter, beispielsweise periodischer Variation des angelegten elektrischen Stromes I und/oder des äußeren Magnetfeldes H ist es somit in einfacher Weise möglich, auch eine Torsionsschwingung der Spiegelfläche 10 anzuregen.

Das erläuterte Ausführungsbeispiel eignet sich jedoch offensichtlich auch für eine statische Auslenkung der Spiegelfläche 10.

Insgesamt ist es zur Erzielung einer möglichst großen Kraft beziehungsweise eines möglichst großen Drehmomentes auf die Spiegelfläche 10 im erläuterten Beispiel zweckmäßig, die Leiterbahnen 15, 15' zumindest einseitig auf der Oberfläche der Spiegelfläche 10 derart zu führen, daß in dem äußeren Magnetfeld H ein möglichst großer magnetischer Fluß von den Leiterbahnen 15, 15' eingeschlossen wird.

Die Figur 3 erläutert in Weiterführung von Figur 2 ein weiteres Ausführungsbeispiel der Erfindung, das sich von der Figur 2 lediglich dadurch unterscheidet, daß die Spiegelfläche 10 durch eine entsprechende geeignete Herausstrukturierung aus dem Tragkörper 11, 12 seitliche Schleifen 16, 16' aufweist. Diese Schleifen 16, 16' sind bevorzugt symmetrisch angeordnet und dienen primär der Vergrößerung des Drehmomentes T beziehungsweise des eingeschlossenen magnetischen Flusses durch Vergrößerung der von den Leiterbahnen 15, 15' umschlossenen Fläche.

Die Schleifen 16, 16' gemäß Figur 3 weisen beispielsweise eine Gesamtlänge von 500 μm bis 1 mm und eine Gesamtbreite von 100 μm bis 500 μm. Ihre Dikke entspricht der Dicke der Spiegelfläche 10. Die Schleifen 16, 16' sind weiter ähnlich den Torsionsbalken 13, 13' ausgebildet, das heißt, sie haben die Form schmaler Stege, die einen Raum umschließen, wobei auf der Oberfläche der Stege die jeweils zugeordnete Leiterbahn 15 beziehungsweise 15' verläuft und diese Oberfläche bevorzugt vollständig bedeckt.

Dadurch daß die Spiegelfläche 10 in Figur 3 mit den Schleifen 16, 16' versehen ist, umschließt die beim Schließen des Stromkreises entstehende Leiterschleife insgesamt eine größere Fläche, so daß bei gleichem Strom I und gleichem äußeren Magnetfeld H ein deutlich erhöhtes Drehmoment T erzeugbar ist.

Das äußere anliegende Magnetfeld hat im übrigen eine Stärke von bevorzugt 1 mTesla bis 1000 mTesla und wird beispielsweise durch einen in der Umgebung der Spiegelfläche 10 angeordneten Permanent- oder Elektromagneten erzeugt.

**Patentansprüche**

1. Mikrospiegel, insbesondere Mikroschwingspiegel, mit einer zumindest weitgehend freitragenden, um mindestens eine Torsionsachse (17) aus der Ruhelage auslenkbaren Spiegelfläche (10), die über mindestens zwei, zumindest näherungsweise parallel nebeneinander geführte Torsionsbalken (13, 13') mit mindestens einem Tragkörper (11, 12) verbunden ist, **dadurch gekennzeichnet, dass** die Spiegelfläche (10) zumindest bereichsweise oberflächlich mit Leiterbahnen (15, 15') versehen ist.

2. Mikrospiegel nach Anspruch 1, **dadurch gekennzeichnet, daß** die Torsionsbalken (13, 13') beabstandet parallel nebeneinander geführt sind.

3. Mikrospiegel nach Anspruch 1 oder 2, **dadurch gekennzeichnet, daß** die Spiegelfläche (10) über vier Torsionsbalken (13, 13') mit dem Tragkörper (11, 12) verbunden ist, wobei jeweils zwei der Torsionsbalken (13, 13') beabstandet nebeneinander angeordnet sind und wobei die vier Torsionsbalken (13, 13') eine gemeinsame Torsionsachse (17) definieren.

**4.** Mikrospiegel nach Anspruch 1, **dadurch gekennzeichnet, daß** die Spiegelfläche (10) zumindest bereichsweise oberflächlich metallisiert ist.

**5.** Mikrospiegel nach mindestens einem der vorangehenden Ansprüche, **dadurch gekennzeichnet, daß** die Spiegelfläche (10) über mindestens eine Leiterbahn (15, 15') elektrisch mit dem Tragkörper (11, 12) verbunden ist, wobei der Tragkörper (11, 12) insbesondere mindestens eine Kontaktfläche (14, 14') aufweist.

**6.** Mikrospiegel nach mindestens einem der vorangehenden Ansprüche, **dadurch gekennzeichnet, daß** Mittel vorgesehen sind, die eine Auslenkung, insbesondere eine statische Torsion oder eine Torsionsschwingung, der Spiegelfläche (10) um die Torsionsachse (17) bewirken.

**7.** Mikrospiegel nach Anspruch 6, **dadurch gekennzeichnet, daß** das Mittel mindestens eine in einer Umgebung der Spiegelfläche (10) angeordnete Elektrode (18) ist, über die mittels elektrostatischer Wechselwirkung die Spiegelfläche (10) aus der Ruhelage auslenkbar oder zu einer Torsionsschwingung anregbar ist.

**8.** Mikrospiegel nach mindestens einem der vorangehenden Ansprüche, **dadurch gekennzeichnet, daß** die Oberfläche der Spiegelfläche (10) bereichsweise mit Leiterbahnen (15, 15') versehen ist, die über die Torsionsbalken (13, 13') elektrisch leitend mit dem Tragkörper (11, 12), insbesondere mit auf dem Tragkörper (11, 12) befindlichen Kontaktflächen (14, 14'), verbunden sind.

**9.** Mikrospiegel nach Anspruch 8, **dadurch gekennzeichnet, daß** die Leiterbahnen (15, 15') jeweils zumindest einseitig flächig auf einer Oberfläche eines zugeordneten Torsionsbalkens (13, 13') verlaufen und insbesondere diese Oberfläche des Torsionsbalkens (13, 13') zumindest weitgehend bedecken.

**10.** Mikrospiegel nach mindestens einem der vorangehenden Ansprüche, **dadurch gekennzeichnet, daß** die Leiterbahnen (13, 13') zumindest einseitig auf der Oberfläche der Spiegelfläche (10) derart verlaufen, daß in einem äußeren Magnetfeld (H) ein möglichst großer magnetischer Fluß von den Leiterbahnen (13, 13') eingeschlossen wird.

**11.** Mikrospiegel nach mindestens einem der vorangehenden Ansprüche, **dadurch gekennzeichnet, daß** die Leiterbahnen (13, 13') zumindest einseitig auf der Oberfläche der Spiegelfläche (10) derart verlaufen, daß in einem äußeren Magnetfeld (H) bei einem durch die Leiterbahnen (13, 13') geführten elektrischen Strom ein möglichst großes Drehmoment auf die Spiegelfläche (10) ausgeübt wird.

**12.** Mikrospiegel nach mindestens einem der vorangehenden Ansprüche, **dadurch gekennzeichnet, daß** die Leiterbahnen (13, 13') auf der Oberfläche der Spiegelfläche (10) in Form einer Leiterschleife geführt sind.

**13.** Mikrospiegel nach mindestens einem der vorangehenden Ansprüche, **dadurch gekennzeichnet, daß** die Spiegelfläche (10) zur Vergrößerung des Drehmomentes und/oder des magnetischen Flusses mindestens eine Schleife (16, 16'), insbesondere zwei symmetrisch aufgebaute Schleifen (16, 16') aufweist, auf deren Oberfläche je eine Leiterbahn (15, 15') verläuft.

**14.** Mikrospiegel nach mindestens einem der vorangehenden Ansprüche, **dadurch gekennzeichnet, daß** die Schleifen (16, 16')ein möglichst geringes Gewicht aufweisen und gleichzeitig in einem äußeren Magnetfeld (H) einen möglichst großen magnetischen Fluß einschließen und/oder bei einem durch die Leiterbahnen (13, 13') geführten elektrischen Strom ein möglichst großes Drehmoment auf die Spiegelfläche (10) ausüben.

**Claims**

**1.** Micro-mirror, in particular an oscillating micromirror, having an at least largely unsupported reflecting face (10) which can be deflected from the rest position about at least one torsion axis (17) and is connected to at least one carrying body (11, 12) via at least two torsion beams (13, 13') guided next to one another in an at least approximately parallel fashion, **characterized in that** the reflecting face (10) is provided at least partially with conductor tracks (15, 15') on the surface.

**2.** Micro-mirror according to Claim 1, **characterized in that** the torsion beams (13, 13') are guided at a spacing next to one another in a parallel fashion.

**3.** Micro-mirror according to Claim 1 or 2, **characterized in that** the reflecting face (10) is connected to the carrying body (11, 12) via four torsion beams (13, 13'), two of the torsion beams (13, 13') in each case being arranged at a spacing next to one another, and the four torsion beams (13, 13') defining a common torsion axis (17).

**4.** Micro-mirror according to Claim 1, **characterized in that** the reflecting face (10) is metallized at least partially on the surface.

**5.** Micro-mirror according to at least one of the preceding claims, **characterized in that** the reflecting face (10) is electrically connected to the carrying body (11, 12) via at least one conductor track (15, 15'), the carrying body (11, 12) having, in particular, at least one contact surface (14, 14').

6. Micro-mirror according to at least one of the preceding claims, **characterized in that** means are provided which effect a deflection, in particular a static torsion or a torsional oscillation of the reflecting face (10) about the torsion axis (17).

7. Micro-mirror according to Claim 6, **characterized in that** the means is at least one electrode (18) which is arranged in the surroundings of the reflecting face (10) and via which it is possible by means of electrostatic interaction to deflect the reflecting face (10) from the rest position, or to excite it to a torsional oscillation.

8. Micro-mirror according to at least one of the preceding claims, **characterized in that** the surface of the reflecting face (10) is provided partially with conductor tracks (15, 15') that are connected in an electrically conducting fashion via the torsion beams (13, 13') to the carrying body (11, 12), in particular with the aid of contact surfaces (14, 14') located on the carrying body (11, 12).

9. Micro-mirror according to Claim 8, **characterized in that** in each case at least at one end, the conductor tracks (15, 15') run in a planar fashion on a surface of an assigned torsion beam (13, 13') and at least largely cover this surface of the torsion beam (13, 13').

10. Micro-mirror according to at least one of the preceding claims, **characterized in that**, at least at one end, the conductor tracks (13, 13') run on the surface of the reflecting face (10) in such a way that as large as possible a magnetic flux is enclosed by the conductor tracks (13, 13') in an external magnetic field (H).

11. Micro-mirror according to at least one of the preceding claims, **characterized in that**, at least at one end, the conductor tracks (13, 13') run on the surface of the reflecting face (10) in such a way that as large as possible a torque is exerted on the reflecting face (10) in an external magnetic field (H) when an electric current is carried through the conductor tracks (13, 13').

12. Micro-mirror according to at least one of the preceding claims, **characterized in that** the conductor tracks (13, 13') are guided on the surface of the reflecting face (10) in the form of a conductor loop.

13. Micro-mirror according to at least one of the preceding claims, **characterized in that** for the purpose of increasing the torque and/or the magnetic flux, the reflecting face (10) has at least one loop (16, 16'), in particular two symmetrically constructed loops (16, 16'), on whose surface a conductor track (15, 15') runs in each case.

14. Micro-mirror according to at least one of the preceding claims, **characterized in that** the loops (16, 16') have as low a weight as possible and include as large a magnetic flux as possible, and/or exert as large as possible a torque on the reflecting face (10) when an electric current is carried through the conductor tracks (13, 13').

## Revendications

1. Micromiroir notamment micromiroir oscillant comportant au moins une surface réfléchissante (10) très largement en porte-à-faux, pouvant être déplacé à partir de sa position de repos autour d'au moins un axe de torsion (17), cette surface réfléchissante étant reliée à au moins un support (11, 12) par au moins deux poutres de torsion (13, 13') sensiblement parallèles juxtaposées,
**caractérisé en ce que**
la surface réfléchissante (10) comporte au moins par zones de surface des chemins conducteurs (15, 15').

2. Micromiroir selon la revendication 1,
**caractérisé en ce que**
les poutres de torsion (13, 13') sont écartées parallèlement l'une à côté de l'autre.

3. Micromiroir selon la revendication 1 ou 2,
**caractérisé en ce que**
la surface réfléchissante (10) est reliée par quatre poutres de torsion (13, 13') au support (11, 12) et chaque fois deux poutres de torsion (13, 13') sont placées l'une à côté de l'autre de manière écartée et au moins les quatre poutres de torsion (13, 13') définissent un axe de torsion (17) commun.

4. Micromiroir selon la revendication 1,
**caractérisé en ce que**
la surface réfléchissante (10) est métallisée en surface au moins par zones.

5. Micromiroir selon au moins l'une des revendications précédentes,
**caractérisé en ce que**
la surface réfléchissante (10) est reliée par au moins un chemin conducteur (15, 15'), électriquement au support (11, 12), ce support (11, 12) ayant notamment au moins une surface de contact (14, 14').

6. Micromiroir selon au moins l'une des revendications précédentes, **caractérisé par** un moyen assurant un déplacement, notamment une torsion statique ou une oscillation de torsion de la surface réfléchissante (10) autour de l'axe de torsion (17).

7. Micromiroir selon la revendication 6, **caractérisé en ce que** le moyen est constitué par au moins une électrode (18) située dans l'environnement de la surface réfléchissante (10), permettant de déplacer la surface réfléchissante (10) de sa position de repos ou de l'exciter pour une oscillation de torsion.

8. Micromiroir selon au moins l'une des revendications précédentes, **caractérisé en ce que** la surface supérieure de la surface réfléchissante (10) est munie au moins par zones de chemins conducteurs (15, 15') reliés électriquement par les poutres de torsion (13, 13') au support (11, 12), notamment avec des surfaces de contact (14, 14') prévues sur le support (11, 12).

9. Micromiroir selon la revendication 8, **caractérisé en ce que** les chemins conducteurs (15, 15') passent chaque fois au moins d'un côté à plat sur la surface supérieure d'une poutre de torsion (13, 13') associée et couvrent au moins dans une grande mesure cette surface supérieure de la poutre de torsion (13, 13').

10. Micromiroir selon au moins l'une des revendications précédentes, **caractérisé en ce que** les chemins conducteurs (13, 13') passent au moins d'un côté sur la surface supérieure de la surface réfléchissante (10) de façon que dans un champ magnétique extérieur (H) les chemins conducteurs (13, 13') englobent un flux magnétique aussi grand que possible.

11. Micromiroir selon au moins l'une des revendications précédentes, **caractérisé en ce que** les chemins conducteurs (13, 13') passent au moins d'un côté sur la face supérieure de la surface du miroir (10) de sorte que dans un champ magnétique extérieur (H), le courant électrique passant par les chemins conducteurs (13, 13') engendre un couple aussi grand que possible exercé sur la surface réfléchissante (10).

12. Micromiroir selon au moins l'une des revendications précédentes, **caractérisé en ce que** les chemins conducteurs (13, 13') sont tracés sur la surface supérieure de la surface réfléchissante sous la forme d'une boucle conductrice.

13. Micromiroir selon au moins l'une des revendications précédentes, **caractérisé en ce que** pour augmenter le couple et/ou le flux magnétique, au moins une boucle (16, 16'), notamment deux boucles symétriques (16, 16'), sont prévues sur la surface réfléchissante avec sur sa surface supérieure chaque fois un chemin conducteur (15, 15').

14. Micromiroir selon au moins l'une des revendications précédentes, **caractérisé en ce que** les boucles (16, 16') ont un poids aussi réduit que possible et en même temps dans un champ magnétique extérieur (H) enferment un flux magnétique aussi grand que possible, et/ou le courant électrique passant dans les chemins conducteurs (13, 13') donne un couple aussi grand que possible exercé sur la surface réfléchissante (10).

FIG. 1

FIG. 2

FIG. 3